# FASCICULE DE BREVET EUROPEEN

(11) **EP 3 467 054 B1**
(45) Date de publication et mention de la délivrance du brevet: **20.05.2020**
(21) Numéro de dépôt: 18197006.2
(22) Date de dépôt: 26.09.2018
(51) Int. Cl.: C09D 11/037, C09D 11/52, H05K 1/09, H05K 3/12, B82Y 30/00

(54) **PROCEDE AMELIORE D'IMPRESSION D'UN SUBSTRAT PAR JET D'AEROSOL, ET SYSTEME D'IMPRESSION POUR LA MISE EN OEUVRE DU PROCEDE**
VERBESSERTES DRUCKVERFAHREN EINES SUBSTRATS DURCH EINEN AEROSOLSTRAHL UND DRUCKSYSTEM ZUM DURCHFÜHREN DES VERFAHRENS
IMPROVED SUBSTRATE PRINTING PROCESS BY AEROSOL JET AND PRINTING SYSTEM FOR CARRYING OUT THE PROCESS

(30) Priorité: 05.10.2017 FR 1759344
(43) Date de publication de la demande: 10.04.2019
(73) Titulaire: Commissariat à l'énergie atomique et aux énergies alternatives, 75015 Paris (FR)
(72) Inventeur: SOLAN, Sébastien, 38170 SEYSSINET-PARISET (FR); THOMAS, Yohann, 38100 GRENOBLE (FR)
(74) Mandataire: Brevalex

(56) Documents cités:
- EP-A2- 2 442 367
- EP-A2- 2 649 141
- WO-A2-2009/026126
- US-A1- 2017 181 291
- US-A1- 2017 253 757

## Description

L'invention se rapporte au domaine général de l'impression d'un substrat avec une encre à base de nanoparticules métalliques.

L'invention s'applique préférentiellement à la fabrication de produits destinés à intégrer des conducteurs déposés par impressions. Ces conducteurs peuvent être des pistes électroniques pour des pièces dans le domaine de l'électronique organique. Ils peuvent également servir de couches actives pour piles à combustible et électrolyseurs, pour la production de catalyseurs. De tels connecteurs peuvent également former des collecteurs de courant pour batteries, ou encore des pistes d'argent pour des pièces du domaine photovoltaïque. D'autres applications sont néanmoins possibles, comme dans le domaine des capteurs.

De l'art antérieur, il est connu d'utiliser des encres conductrices pour imprimer des substrats, via une technique d'impression par jet d'aérosol. Une telle technique est par exemple connue du document EP 2 649 141. Cependant, l'obtention de telles encres métalliques peut s'avérer délicate et compliquée, c'est la raison pour laquelle le but de l'invention réside dans la simplification de la mise en œuvre d'un tel procédé d'impression.

Pour répondre à ce but, l'invention a pour objet un procédé d'impression d'un substrat par jet d'aérosol comprenant des nanoparticules métalliques, le procédé comprenant la mise en œuvre des étapes successives suivantes :
a) une étape de préparation d'une solution comprenant lesdites nanoparticules métalliques, à l'aide d'une solution comprenant au moins un précurseur métallique desdites nanoparticules métalliques ainsi qu'au moins un agent réducteur du ou des précurseurs ;
b) une étape de génération d'un aérosol comprenant des nanoparticules métalliques, par alimentation en continu d'un dispositif de génération d'aérosol avec la solution obtenue à l'étape a) ; et
c) une étape d'impression du substrat au moyen d'une tête d'impression alimentée en continu par l'aérosol obtenu à l'étape b).

En d'autres termes, l'invention prévoit l'impression en continu à partir d'une solution comprenant les nanoparticules métalliques, elle-même obtenue à partir d'une solution comprenant au moins un précurseur métallique des nanoparticules métalliques, ainsi qu'au moins un agent réducteur du ou des précurseurs. Ainsi, le procédé est simplifié en ce qu'il ne nécessite pas d'étapes post-synthèse des nanoparticules, mais il est au contraire mis en œuvre de façon à utiliser directement la solution contenant ces nanoparticules synthétisées. En particulier, le procédé est avantageux en ce qu'il ne requiert pas d'étape post-synthèse du type filtration, purification, séchage, ou autre.

Par ailleurs, l'invention prévoit de préférence au moins l'une des caractéristiques optionnelles suivantes, prises isolément ou en combinaison.

Selon un premier mode de réalisation préféré de l'invention, l'étape a) est mise en œuvre en alimentant en continu un réacteur micro-ondes avec la solution comprenant au moins un précurseur métallique desdites nanoparticules métalliques ainsi qu'au moins un agent réducteur du ou des précurseurs. L'utilisation d'un réacteur micro-ondes, notamment du type monomodal, possède plusieurs avantages conséquents et reproductibles, parmi lesquels une forte homogénéité de chauffage et un bon transfert de la solution au travers du réacteur.

En outre, il est noté que ce premier mode de réalisation présente l'avantage de permettre une production en continu des nanoparticules métalliques synthétisées dans le réacteur micro-ondes, avec un parfait contrôle de leurs tailles, formes et morphologies.

La solution qui comprend au moins un précurseur métallique desdites nanoparticules métalliques ainsi qu'au moins un agent réducteur du ou des précurseurs, constitue alors la seule source de matière pour l'impression du substrat.

L'étape a) est alors préférentiellement mise en œuvre en faisant circuler la solution dans une canalisation en forme de serpentin prévue au sein du réacteur micro-ondes.

Selon un second mode de réalisation préféré de l'invention, l'étape a) est mise en œuvre en amenant, dans un récipient réactionnel, la solution comprenant au moins un précurseur métallique desdites nanoparticules ainsi qu'au moins un agent réducteur du ou des précurseurs, ladite solution étant chauffée et sous agitation magnétique.

Quel que soit le mode de réalisation envisagé, l'étape a) est de préférence mise en œuvre en chauffant la solution à une température comprise entre 100 et 200°C, et plus préférentiellement entre 120 et 160°C.

Par ailleurs, l'étape b) de génération de l'aérosol est réalisée par voie pneumatique, par ultra-sons, ou par résistance thermique. Cette dernière solution permet une solution plus compacte et simple à mettre en oeuvre.

De préférence, le substrat comprend également une étape de régulation de la pression et/ou du débit de l'aérosol, entre les étapes b) et c).

Préférentiellement, l'étape a) est mise en œuvre par voie polyol pour la réduction du ou des précurseurs métalliques, de préférence en utilisant l'éthylène glycol ou le propylène glycol comme solvant et agent réducteur.

De préférence, la solution comprenant au moins un précurseur métallique desdites nanoparticules métalliques ainsi qu'au moins un agent réducteur du ou des précurseurs, comporte également au moins un agent stabilisant.

Enfin, il est noté que les nanoparticules métalliques produites à l'étape a) présentent une grande dimension inférieure à 3 µm.

L'invention a également pour objet un système d'impression d'un substrat par jet d'aérosol comprenant des nanoparticules métalliques, pour la mise en œuvre du procédé décrit précédemment, le système comprenant le dispositif de génération d'aérosol, la tête d'impression, ainsi qu'un réacteur pour la mise en œuvre de l'étape a), le réacteur communiquant avec le dispositif de génération d'aérosol, et ce dernier communiquant avec la tête d'impression.

D'autres avantages et caractéristiques de l'invention apparaîtront dans la description détaillée non limitative ci-dessous.

Cette description sera faite au regard des dessins annexés parmi lesquels ;
- la figure 1 représente une vue schématique d'un système d'impression selon un premier mode de réalisation préféré de l'invention ;
- la figure 2 représente une vue schématique en perspective du dispositif de génération d'aérosol équipant le système montré sur la figure 1 ;
- la figure 3 représente une vue schématique en coupe transversale du dispositif montré sur la figure 2 ; et
- la figure 4 représente une vue schématique d'une partie d'un système d'impression, selon un second mode de réalisation préféré de l'invention.

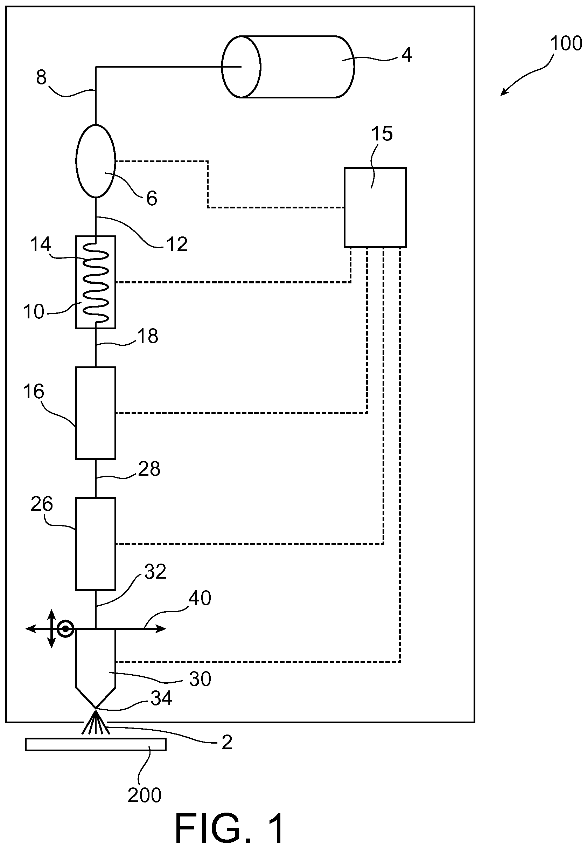

En référence tout d'abord à la figure 1, il est représenté un système d'impression 100 d'un substrat 200, par jet d'aérosol 2 comprenant des nanoparticules métalliques. Le système se présente sous la forme d'un premier mode de réalisation préféré de l'invention. Il est dédié à la fabrication de pièces s'inscrivant dans l'une quelconque des applications énumérées précédemment.

Le système comprend tout d'abord un réservoir 4 destiné à contenir une solution comprenant au moins un précurseur métallique des nanoparticules métalliques à imprimer, ainsi qu'au moins un agent réducteur du ou des précurseurs. Cette solution, qui peut être complétée par d'autres éléments comme cela sera détaillée ci-après, est par la suite dénommée « solution de précurseurs ».

Le réservoir 4 communique avec une pompe 6 par une canalisation 8 qui relie ces deux éléments 4, 6. La pompe est par exemple du type péristaltique. En outre, le système 100 comprend un réacteur micro-ondes 10 communiquant avec la pompe 6, via une canalisation 12 qui relie ces deux éléments 6, 10. Le réacteur 10 est traversé par une canalisation 14 en forme de serpentin, représentée schématiquement sur la figure 1. C'est dans cette canalisation 14 que la solution de précurseurs est destinée à circuler, pour y subir une réaction de réduction conduisant à la synthèse des nanoparticules métalliques désirées. Le temps de séjour de la solution de précurseurs dans le réacteur est régulé par la pompe 6, elle-même commandée par une unité de commande et de contrôle 15 du système. Cette unité 15 commande également le réacteur 10, ainsi que l'ensemble des composants du système qui vont à présent être décrits.

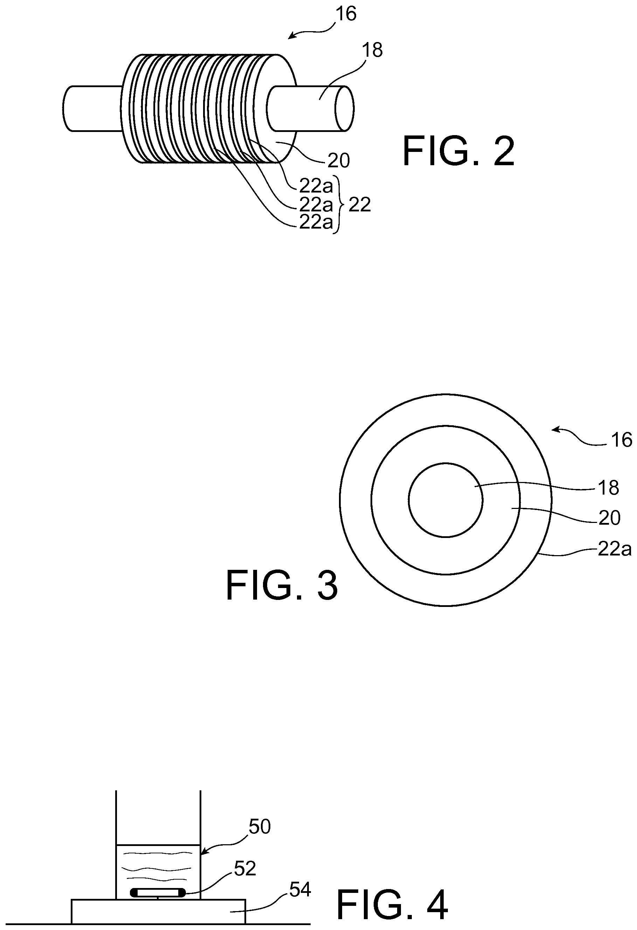

Il s'agit tout d'abord d'un dispositif de génération d'aérosol 16, communiquant avec le réacteur 10 via une canalisation 18 qui relie ces deux éléments 10, 16. Le dispositif 16 est préférentiellement du type thermique, dont un exemple de réalisation est représenté sur les figures 2 et 3. Il comprend un bloc d'isolation électrique 20 agencé autour de la canalisation 18, ce bloc étant par exemple réalisé en alumine. Une résistance électrique chauffante 22 serpente autour de ce bloc, et les spires 22a de cette résistance sont séparées axialement les unes des autres par ce même bloc 20. La résistance 22 est choisie et commandée de telle sorte que la solution qui en sort soit vaporisée, à la manière des systèmes analogues équipant les cigarettes électroniques. D'autres types de dispositifs de génération d'aérosol sont néanmoins possibles, par voie pneumatique ou ultra-sons, sans sortir du cadre de l'invention.

Le dispositif 16 communique quant à lui avec un régulateur 26 de pression et/ou de débit, via une canalisation 28 qui relie ces deux éléments 16, 26.

Enfin, le système comporte une tête d'impression 30 communiquant avec le régulateur 26, via une communication 32 qui relie ces deux éléments 26, 30. L'orifice de sortie 36 de la tête d'impression 30 présente un diamètre compris entre 50 µm et 1 mm. La tête 30 est préférentiellement réalisée dans un matériau inerte du type alumine. Elle est commandée et contrôlée par l'unité 15. Notamment, le système pourrait comprendre plusieurs voies différentes, chacune permettant l'alimentation de la tête avec des nanoparticules de natures différentes. L'unité 15 pourrait alors commander cette alimentation depuis la tête 30, en fonction des matériaux à pulvériser sur le substrat, à chaque instant de l'impression.

Par ailleurs, la tête 30 est préférentiellement couplée à un dispositif permettant sa mise en mouvement, représenté très schématiquement et référencé 40 sur la figure 1. Ce dispositif 40 permet d'appliquer à la tête 30 le mouvement requis, afin d'effectuer sur le substrat 200 une impression selon la géométrie désirée.

Un premier mode de réalisation du procédé d'impression va maintenant être décrit. Il est mis en œuvre à l'aide du système 100 décrit ci-dessus.

Tout d'abord, la solution de précurseurs est chargée dans le réservoir. Cette solution comporte les éléments ci-dessous, et de préférence uniquement constituée de ces éléments :
- un ou des précurseurs métalliques des nanoparticules à déposer sur le substrat. Il peut s'agir de précurseurs des éléments métalliques suivants Pt, Ru, Pd, Ni, Ag, Cu, Au. A titres d'exemples non limitatifs, il est utilisé des sels métalliques du type NiCl2.6H2O, Ni(OH)2, ou encore HAuCl4.3H2O. Les précurseurs peuvent néanmoins être exempts de chlorure de sodium.
- un ou des agents réducteurs des précurseurs. De préférence, la réduction des précurseurs s'effectue par voie polyol, en utilisant préférentiellement l'éthylène glycol ou le propylène glycol qui remplit également la fonction de solvant dans la solution.
- un solvant (lorsqu'il n'est pas déjà présent de par l'utilisation du polyol précité).
- éventuellement, un ou des agents favorisant le pouvoir réducteur du polyol, par exemple NaOH ou LiOH, dit base forte.
- éventuellement, un ou des agents de nucléation, comme un sel de platine ou de palladium. Il peut par exemple d'agir d'acétate de palladium.
- éventuellement, un ou des agents stabilisants pour les nanoparticules, comme par exemple PVP (polyvinylpyrrolidone), PAA (poly(acide acrylique)), PAA-Li (lithium polyacrylate), PAA-Na (sodium polyacrylate), SDS (dodécylsulfate de sodium).
- éventuellement, des supports carbonés pour obtenir les nanoparticules métalliques supportées par du carbone. Par exemple, il peut être utilisé du noir de carbone, graphène ou des nanotubes de carbone.
- éventuellement, un ou des agents dispersants, pour faciliter le frittage ou l'auto-frittage des nanoparticules après leur dépôt sur le substrat. Il peut s'agir par exemple de polyDDA (Polydiallyldimethylammonium chloride).

Lorsque cette solution de précurseurs est chargée dans le réservoir 4, la pompe 6 permet de l'introduire selon un flux continu dans le réacteur 10, via la canalisation 8. En passant en continu dans le serpentin 14 du réacteur, les sels métalliques sont réduits en nanoparticules métalliques. La solution est portée à une température de préférence comprise entre 120 et 160° lors de son passage dans le serpentin, pendant une durée suffisante pour obtenir la réduction de l'ensemble des sels. Par conséquent, il ressort de ce réacteur 10 une solution comprenant les nanoparticules ainsi que le milieu réactionnel, cette solution étant dénommée « solution de nanoparticules métalliques ». Celle-ci est ensuite acheminée en continu dans le dispositif de génération d'aérosol 16, via la canalisation 18.

En passant dans ce dispositif 16, la solution de nanoparticules métalliques est vaporisée pour former un aérosol, sous forme donc d'une suspension gazeuse de nanoparticules métalliques dont la grande dimension est inférieure à 3 µm. Cette grande dimension peut être réduite à des dimensions allant de 100 à 150 nm.

Ensuite, le débit et/ou la pression de l'aérosol sont régulés par le régulateur 26 avant que cet aérosol ne soit acheminé en continu via la canalisation 32 dans la tête d'impression 30, à partir de laquelle l'aérosol est pulvérisé sur le substrat 200. Cette dernière étape correspond à l'impression du substrat par le jet d'aérosol 2.

Un exemple de mise en œuvre du premier mode de réalisation est présenté ci-dessous.

### Exemple 1

Une solution A est préparée à partir d'éthylène glycol (EG) et de NaOH (obtenue en mélangeant une masse de 1,8 g de NaOH pour un volume total de 500 mL d'EG). Une masse de 50 mg de supports carbonés (de type nanotubes de carbone) est dispersée dans 40 mL de la solution A. A ce mélange, une solution de précurseurs métalliques est ajoutée, obtenue préalablement en dissolvant une masse de 107 mg de H2PtCl6.6H2O dans 10 mL de la solution A. Une fois le tout homogénéisé, la solution est introduite en continu dans le four à micro-onde (modèle Mars® commercialisé par la société CEM Corporation®). La synthèse du catalyseur de platine est réalisée pendant un temps de séjour de 30 minutes dans le four, à une température de 160°C. La puissance du four est régulée automatiquement pour maintenir cette température. Après cette étape, la solution contenant le catalyseur de platine, supporté sur des nanotubes de carbone, est injectée en continu dans le dispositif de génération d'aérosol, puis l'aérosol est projeté sur le substrat grâce à la tête d'impression.

La figure 4 représente une partie d'un second mode de réalisation préféré de l'invention, dans lequel le système ne comprend plus un réacteur micro-ondes, ce dernier étant remplacé par un récipient réactionnel 50 recevant la solution de précurseurs. Cette solution est destinée à être chauffée dans le récipient par un support chauffant 54 ou par d'autres moyens conventionnels, à une température sensiblement analogue à celle mentionnée dans le cadre du premier mode de réalisation préféré. Elle est également agitée par un barreau magnétique 52 situé dans le récipient.

Lorsque l'ensemble des sels métalliques sont réduits, la solution de nanoparticules métalliques qui se trouve dans le récipient réactionnel 50 est ensuite distribuée en continu dans le dispositif de génération d'aérosol 16 du système, dont les éléments situés en aval restent identiques à ceux présentés dans le cadre du premier mode de réalisation préféré de l'invention.

Différents exemples de mise en œuvre du second mode de réalisation sont présentés ci-dessous.

### Exemple 2

Il est utilisé un sel métallique de NiCl2.6H2O. Une masse de 0,5 g de ce sel est mélangée avec 12,5 g d'éthylène glycol (EG), ainsi qu'avec 125 g de PVP (4% en masse dans l'EG). La solution est placée sous agitation magnétique pendant 30 minutes, puis chauffée à 120°C pendant une heure. Il est ensuite ajouté alors 2 mL d'une solution de NaOH dans l'EG. Un changement de coloration apparait (du vert translucide au vert opaque, en raison de la formation de Ni(OH)2). La solution est ensuite maintenue sous agitation à 200°C pendant une heure supplémentaire.

Afin d'obtenir la réduction du sel de nickel en nanoparticules de nickel, un agent de nucléation est introduit. Pour cela, une solution d'acétate de palladium est préparée à 0,1% en masse dans l'EG. Après l'ajout de 5 gouttes de cette solution, la solution dans le récipient réactionnel change de couleur (passe au noir) en seulement 30 secondes, indiquant la formation de ces nanoparticules de nickel.

### Exemple 3

Il est utilisé un sel métallique de Ni(OH)2. Une masse de 0,504 g de ce sel sont mélangés avec 14,08 g d'EG ainsi qu'avec 12,6 g de PAA-Li (4% en masse dans l'EG). L'ensemble est ensuite placé sous agitation magnétique pendant 30 minutes. Il est alors ajouté 2 mL d'une solution de NaOH dans l'EG, ainsi que 10 gouttes d'une solution de palladium (Pd(acetate) dans l'EG, à 0,1% en masse). Le tout est chauffé à la température d'ébullition de l'EG. Après deux heures, le chauffage est arrêté, et l'agitation est maintenue jusqu'à refroidissement de la solution contenant les nanoparticules de nickel synthétisées.

### Exemple 4

250 mg de HAuCl4,3H2O sont dissous dans 12,5 mL d'EG. Une masse de 12,5 mL de PVP (4% en masse dans l'EG) sont alors ajoutés. Le tout est placé sous agitation mécanique pendant 30 minutes, puis l'ensemble est chauffé à 120°C. Le changement de couleur indiquant la formation des nanoparticules se produit lors de l'ajout de 0,4 g de NaOH. La concentration de NaOH est alors environ 20 fois celle du celle d'or. Il est ensuite maintenu le tout pendant deux heures supplémentaires. Une fois refroidie, la solution intégrant les nanoparticules d'or synthétisées est directement récupérée sans filtration, ni séchage ou autre purification.

Bien entendu, diverses modifications peuvent être apportées par l'homme du métier à l'invention qui vient d'être décrite, et qui est définie par les revendications ci-jointes.

## Revendications

1. Procédé d'impression d'un substrat (200) par jet d'aérosol (2) comprenant des nanoparticules métalliques, le procédé comprenant la mise en œuvre des étapes successives suivantes :
a) une étape de préparation d'une solution comprenant lesdites nanoparticules métalliques, à l'aide d'une solution comprenant au moins un précurseur métallique desdites nanoparticules métalliques ainsi qu'au moins un agent réducteur du ou des précurseurs ;
b) une étape de génération d'un aérosol comprenant des nanoparticules métalliques, par alimentation en continu d'un dispositif (16) de génération d'aérosol avec la solution obtenue à l'étape a) ;
c) une étape d'impression du substrat (200) au moyen d'une tête d'impression (30) alimentée en continu par l'aérosol obtenu à l'étape b).

2. Procédé selon la revendication 1, **caractérisé en ce que** l'étape a) est mise en œuvre en alimentant en continu un réacteur micro-ondes (10) avec la solution comprenant au moins un précurseur métallique desdites nanoparticules métalliques ainsi qu'au moins un agent réducteur du ou des précurseurs.

3. Procédé selon la revendication 2, **caractérisé en ce que** l'étape a) est mise en œuvre en faisant circuler la solution dans une canalisation en forme de serpentin (14) prévue au sein du réacteur micro-ondes (10).

4. Procédé selon la revendication 1, **caractérisé en ce que** l'étape a) est mise en œuvre en amenant, dans un récipient réactionnel (50), la solution comprenant au moins un précurseur métallique desdites nanoparticules ainsi qu'au moins un agent réducteur du ou des précurseurs, ladite solution étant chauffée et sous agitation magnétique.

5. Procédé selon l'une quelconque des revendications précédentes, **caractérisé en ce que** l'étape a) est mise en œuvre en chauffant la solution à une température comprise entre 100 et 200°C, et plus préférentiellement entre 120 et 160°C.

6. Procédé selon l'une quelconque des revendications précédentes, **caractérisé en ce que** l'étape b) de génération de l'aérosol est réalisée par voie pneumatique, par ultra-sons, ou par résistance thermique.

7. Procédé selon l'une quelconque des revendications précédentes, **caractérisé en ce qu'**il comprend également une étape de régulation de la pression et/ou du débit de l'aérosol, entre les étapes b) et c).

8. Procédé selon l'une quelconque des revendications précédentes, **caractérisé en ce que** l'étape a) est mise en œuvre par voie polyol pour la réduction du ou des précurseurs métalliques, de préférence en utilisant l'éthylène glycol ou le propylène glycol comme solvant et agent réducteur.

9. Procédé selon l'une quelconque des revendications précédentes, **caractérisé en ce que** la solution comprenant au moins un précurseur métallique desdites nanoparticules métalliques ainsi qu'au moins un agent réducteur du ou des précurseurs, comporte également au moins un agent stabilisant.

10. Procédé selon l'une quelconque des revendications précédentes, **caractérisé en ce que** les nanoparticules métalliques produites à l'étape a) présentent une grande dimension inférieure à 3 µm.

11. Système d'impression (100) d'un substrat (200) par jet d'aérosol (2) comprenant des nanoparticules métalliques, pour la mise en œuvre du procédé selon l'une quelconque des revendications précédentes, le système comprenant le dispositif de génération d'aérosol (16), la tête d'impression (30), ainsi qu'un réacteur (10) pour la mise en œuvre de l'étape a), le réacteur (10) communiquant avec le dispositif de génération d'aérosol (16), et ce dernier communiquant avec la tête d'impression (30).

## Patentansprüche

1. Verfahren zum Bedrucken eines Substrats (200) mit einem Aerosolstrahl (2), der metallische Nanopartikel enthält, wobei das Verfahren die Ausführung der nachstehenden, aufeinanderfolgenden Schritte umfasst:
a) einen Schritt der Herstellung einer Lösung, die die metallischen Nanopartikel enthält, unter Verwendung einer Lösung, die mindestens einen metallischen Vorläufer der metallischen Nanopartikel sowie mindestens ein Reduktionsmittel für den bzw. die Vorläufer enthält;
b) einen Schritt der Erzeugung eines Aerosols, das metallische Nanopartikel enthält, durch kontinuierliches Zuführen der in Schritt a) erhaltenen Lösung zu einer Aerosolerzeugungsvorrichtung (16);
c) einen Schritt des Bedruckens des Substrats (200) mit Hilfe eines Druckkopfes (30), dem kontinuierlich das in Schritt b) erhaltene Aerosol zugeführt wird.

2. Verfahren nach Anspruch 1,
**dadurch gekennzeichnet, dass**
der Schritt a) ausgeführt wird, indem die Lösung, die mindestens einen metallischen Vorläufer der metallischen Nanopartikel sowie mindestens ein Reduktionsmittel für den bzw. die Vorläufer enthält, kontinuierlich einem Mikrowellenreaktor (10) zugeführt wird.

3. Verfahren nach Anspruch 2,
**dadurch gekennzeichnet, dass**
der Schritt a) ausgeführt wird, indem die Lösung in einem innerhalb des Mikrowellenreaktors (10) vorgesehenen schlangenlinienförmigen Kanal umgewälzt wird.

4. Verfahren nach Anspruch 1,
**dadurch gekennzeichnet, dass**
der Schritt a) ausgeführt wird, indem die Lösung, die mindestens einen metallischen Vorläufer der Nanopartikel sowie mindestens ein Reduktionsmittel für den bzw. die Vorläufer enthält, in ein Reaktionsgefäß (50) eingeführt wird, wobei die Lösung erhitzt und magnetisch gerührt wird.

5. Verfahren nach einem der vorangehenden Ansprüche,
**dadurch gekennzeichnet, dass**
der Schritt a) ausgeführt wird, indem die Lösung auf eine Temperatur zwischen 100 und 200 °C, vorzugsweise zwischen 120 und 160 °C, erhitzt wird.

6. Verfahren nach einem der vorangehenden Ansprüche,
**dadurch gekennzeichnet, dass**
der Schritt b) der Erzeugung des Aerosols pneumatisch, durch Ultraschall oder durch thermischen Widerstand erfolgt.

7. Verfahren nach einem der vorangehenden Ansprüche,
**dadurch gekennzeichnet, dass**
es ferner einen Schritt des Einstellens von Druck und Durchflussrate des Aerosols zwischen den Schritten b) und c) umfasst.

8. Verfahren nach einem der vorangehenden Ansprüche,
**dadurch gekennzeichnet, dass**
der Schritt a) mittels Polyols zur Reduktion des bzw. der metallischen Vorläufer ausgeführt wird, vorzugsweise unter Verwendung von Ethylenglykol oder Propylenglykol als Lösungsmittel und Reduktionsmittel.

9. Verfahren nach einem der vorangehenden Ansprüche,
**dadurch gekennzeichnet, dass**
die Lösung, die mindestens einen metallischen Vorläufer der genannten metallischen Nanopartikel sowie mindestens ein Reduktionsmittel für den bzw. die Vorläufer enthält, auch mindestens ein Stabilisierungsmittel enthält.

10. Verfahren nach einem der vorangehenden Ansprüche,
**dadurch gekennzeichnet, dass**
die größte Abmessung der in Schritt a) hergestellten metallischen Nanopartikel weniger als 3 µm beträgt.

11. System (100) zum Bedrucken eines Substrats (200) mit einem Aerosolstrahl (2), der metallische Nanopartikel enthält, zum Durchführen des Verfahrens nach einem der vorangehenden Ansprüche, wobei das System die Aerosolerzeugungsvorrichtung (16), den Druckkopf (30) sowie einen Reaktor (10) zum Ausführen von Schritt a) enthält, wobei der Reaktor (10) mit der Aerosolerzeugungsvorrichtung (16) kommuniziert ist und wobei letztere mit dem Druckkopf (30) kommuniziert.

## Claims

1. Method for printing a substrate (200) using an aerosol jet (2) comprising metallic nanoparticles, the method comprising implementation of the following successive steps:
a) a step to prepare a solution comprising said metallic nanoparticles, using a solution comprising at least one metallic precursor of said metallic nanoparticles, and at least one reducing agent of the precursor(s),
b) a step to generate an aerosol containing metallic nanoparticles, by continuous feed of an aerosol generation device (16) with the solution obtained in step a),
c) a step to print the substrate (200) using a print head (30) continuously supplied with the aerosol obtained in step b).

2. Method according to claim 1, **characterised in that** step a) is implemented by continuously supplying a microwave reactor (10) with the solution comprising at least one metallic precursor of said metallic nanoparticles and at least one reducing agent of the precursor(s).

3. Method according to claim 1, **characterised in that** step a) is implemented by circulating the solution in a coiled pipe (14) provided within the microwave reactor (10).

4. Method according to claim 1, **characterised in that** step a) is implemented by bringing the solution comprising at least one metallic precursor of said nanoparticles and at least one reducing agent of the precursor(s) into a reaction vessel (50), said solution being heated and magnetically stirred.

5. Method according to any one of the previous claims, **characterised in that** step a) is implemented by heating the solution to a temperature of between 100 and 200°C, and more preferably between 120°C and 160°C.

6. Method according to any one of the previous claims, **characterised in that** the aerosol generation step b) is implemented pneumatically, by ultrasound or by thermal resistance.

7. Method according to any one of the previous claims, **characterised in that** it also comprises an aerosol pressure and/or flow regulation step, between steps b) and c).

8. Method according to any one of the previous claims, **characterised in that** step a) is implemented using polyol for reduction of the metallic precursor(s), preferably using ethylene glycol or propylene glycol as solvent and reducing agent.

9. Method according to any one of the previous claims, **characterised in that** the solution comprising at least one metallic precursor of said metallic nanoparticles and at least one reducing agent of the precursor(s) also comprises at least one stabilising agent.

10. Method according to any one of the previous claims, **characterised in that** the large dimension of the metallic nanoparticles produced in step a) is less than 3 µm.

11. System (100) for printing a substrate (200) by an aerosol jet (2) comprising metallic nanoparticles, for implementation of the method according to any one of the previous claims, the system comprising the aerosol generation device (16), the print head (30) and a reactor (10) for implementation of step a), the reactor (10) communicating with the aerosol generation device (16), and the latter communicating with the print head (30).
